(19) Europäisches Patentamt
European Patent Office
Office européen des brevets

(11) **EP 4 303 658 A1**

(12) **EUROPEAN PATENT APPLICATION**

(43) Date of publication:
**10.01.2024 Bulletin 2024/02**

(51) International Patent Classification (IPC):
***G03F 7/20*** *(2006.01)*      ***G03F 9/00*** *(2006.01)*

(21) Application number: **22183121.7**

(52) Cooperative Patent Classification (CPC):
**G03F 7/70616; G03F 9/7092**

(22) Date of filing: **05.07.2022**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **MENCHTCHIKOV, Boris**
**San Jose, 95134 (US)**
• **TABERY, Cyrus, Emil**
**San Jose, 95134 (US)**

(74) Representative: **ASML Netherlands B.V.**
**Corporate Intellectual Property**
**P.O. Box 324**
**5500 AH Veldhoven (NL)**

(54) **METHOD OF CORRECTION METROLOGY SIGNAL DATA**

(57)      Disclosed is a method of correcting metrology signal data relating to a structure on a substrate. The method comprises obtaining measured metrology signal data related to a measurement of the structure on a substrate with measurement radiation; obtaining simulated metrology signal data related to a simulated measurement of a model of said structure using said measurement radiation; and using the simulated metrology signal data to correct the measured metrology signal data for at least a polarization dependent offset in the measured metrology signal data resultant from an asymmetry in said structure, to obtain corrected measured metrology signal data.

Fig. 4

**Description**

FIELD OF THE INVENTION

The present invention relates to methods and apparatus usable, for example, in the manufacture of devices by lithographic techniques, and to methods of manufacturing devices using lithographic techniques. The invention relates more particularly to metrology sensors and lithography apparatuses having such a metrology sensor.

BACKGROUND ART

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of a die, one die, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. These target portions are commonly referred to as "fields".

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down (by the same apparatus or a different lithographic apparatus) in previous layers. For this purpose, the substrate is provided with one or more sets of alignment marks. Each mark is a structure whose position can be measured at a later time using a position sensor, typically an optical position sensor. The lithographic apparatus includes one or more alignment sensors by which positions of marks on a substrate can be measured accurately. Different types of marks and different types of alignment sensors are known from different manufacturers and different products of the same manufacturer.

In other applications, metrology sensors are used for measuring exposed structures on a substrate (either in resist and/or after etch). A fast and non-invasive form of specialized inspection tool is a scatterometer in which a beam of radiation is directed onto a target on the surface of the substrate and properties of the scattered or reflected beam are measured. Examples of known scatterometers include angle-resolved scatterometers of the type described in US2006033921A1 and US2010201963A1. In addition to measurement of feature shapes by reconstruction, diffraction based overlay can be measured using such apparatus, as described in published patent application US2006066855A1. Diffraction-based overlay metrology using dark-field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

Conventional alignment marks and metrology targets may comprise gratings which diffract incident radiation. In an alignment context, when the alignment marks are ideally perfectly symmetric, assuming no mark deformation, the measurement error in aligned position error is zero, resulting in the best overlay. Similarly an ideal overlay target would have asymmetry attributable to overlay only. However, as a result of processing, such as etching, chemical-mechanical polishing (CMP), annealing, deposition, oxidation, etc., real alignment marks and overlay targets are deformed in various ways, often resulting in asymmetries, which are not known beforehand. Typical asymmetries observed include Floor Tilt (FT), Top Tilt (TT) and Side Wall Angle (SWA). Furthermore, due to fluctuation in the processing, the depth of alignment marks/overlay targets can also vary around the nominal value.

Measurement of the aforementioned perfectly symmetric alignment mark with multiple wavelengths and/or polarizations will return the same measured position for each wavelengths and/or polarization. However, asymmetric imperfection may result in a wavelength/polarization dependent variation in a measured value from the target or mark. Correction and/or mitigation for this variation is sometimes effected by performing a measurement using an optimized measurement condition or illumination condition (e.g., optimized different wavelengths and/or polarizations) for the target/stack being measured and/or providing a weighting per color or polarization, an approach known as optimal color weighting (OCW).

It would be desirable to improve on present methods for correcting measurements of a mark or target for measurement errors resultant from asymmetry in the mark/target.

SUMMARY OF THE INVENTION

The invention in a first aspect provides a method of correcting metrology signal data relating to a structure on a substrate, the method comprising: obtaining measured metrology signal data related to a measurement of the structure on a substrate with measurement radiation; obtaining simulated metrology signal data related to a simulated measurement of a model of said structure using said measurement radiation; and using the simulated metrology signal data to correct the measured metrology signal data for at least a polarization dependent offset in the measured metrology signal data resultant from an asymmetry in said structure, to obtain corrected measured metrology signal data.

Also disclosed is a computer program comprising program instructions operable to perform the method of the first aspect, a non-transient computer program carrier comprising the computer program, a processing arrangement comprising the non-transient computer program carrier, a metrology apparatus comprising the processing arrangement, an alignment sensor comprising the processing arrangement, and a lithographic apparatus comprising the alignment sensor.

Also is disclosed a further lithographic apparatus comprising a metrology apparatus being operable to perform the method of the first aspect.

The above and other aspects of the invention will be understood from a consideration of the examples described below.

BRIEF DESCRIPTION OF THE DRAWINGS

Embodiments of the invention will now be described, by way of example only, with reference to the accompanying drawings, in which:

Figure 1 depicts a lithographic apparatus;
Figure 2 illustrates schematically measurement and exposure processes in the apparatus of Figure 1;
Figure 3 is a schematic illustration of an alignment sensor adaptable according to an embodiment of the invention;
Figure 4 schematically illustrates an issue of exposing a subsegmented alignment mark out of focus, and in particular using an EUV metrology tool;
Figure 5 is a plot of critical dimension (CD) against sub-feature index of a single subsegmented alignment mark feature, for a number of different focus settings; and
Figure 6(a) to (c) show swing curves respectively for simulated data, measured data and corrected measured data using an embodiment of the invention.

DETAILED DESCRIPTION OF EMBODIMENTS

Before describing embodiments of the invention in detail, it is instructive to present an example environment in which embodiments of the present invention may be implemented.

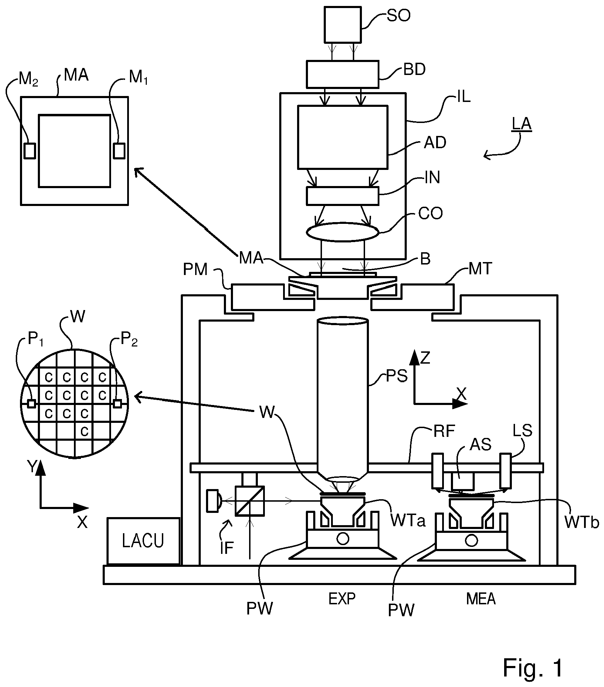

Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

The illumination system may include various types of optical components, such as refractive, reflective, magnetic, electromagnetic, electrostatic or other types of optical components, or any combination thereof, for directing, shaping, or controlling radiation.

The patterning device support MT holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment marks may also be included within dies, in amongst the device features, in which case it is desirable that the markers be as small as possible and not require any different imaging or process conditions than adjacent features. The alignment system, which detects the alignment markers is described further below.

The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

Combinations and/or variations on the above described modes of use or entirely different modes of use may also be employed.

Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

In other embodiments, the lithography apparatus LA may comprise an illumination system (illuminator) IL configured to condition an EUV (extreme ultraviolet) radiation beam (e.g., having a wavelength in the range of 1-100 nm). In this embodiment, the lithography apparatus LA may be configured to pattern a substrate by using EUV radiation beam or beams.

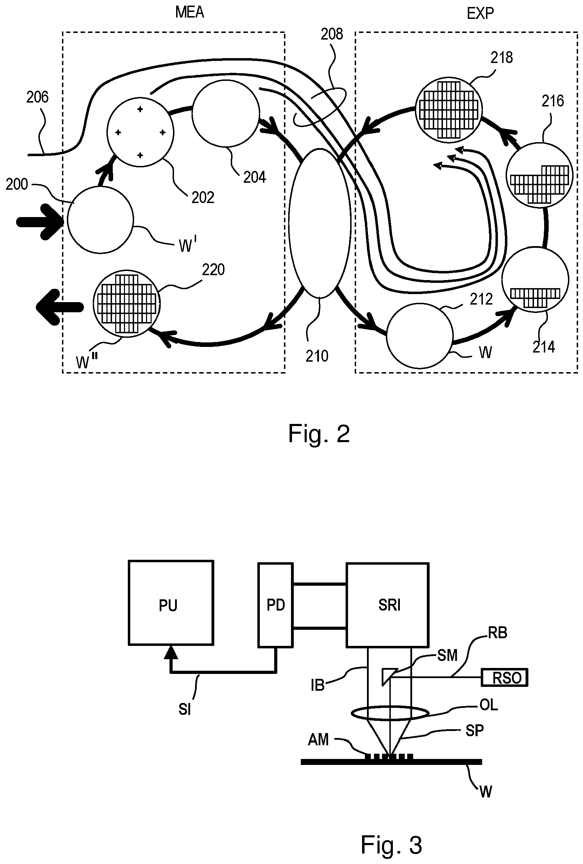

Figure 2 illustrates the steps to expose target portions (e.g. dies) on a substrate W in the dual stage apparatus of Figure 1. On the left hand side within a dotted box are steps performed at a measurement station MEA, while the right hand side shows steps performed at the exposure station EXP. From time to time, one of the substrate tables WTa, WTb will be at the exposure station, while the other is at the measurement station, as described above. For the purposes of this description, it is assumed that a substrate W has already been loaded into the exposure station. At step 200, a new substrate W' is loaded to the apparatus by a mechanism not shown. These two substrates are processed in parallel in order to increase the throughput of the lithographic apparatus.

Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well. Particularly for the problem of improving overlay performance, the task is to ensure that new patterns are applied in exactly the correct position on a substrate that has already been subjected to one or more cycles of patterning and processing. These processing steps progressively introduce distortions in the substrate that must be measured and corrected for, to achieve satisfactory overlay performance.

The previous and/or subsequent patterning step may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

At 202, alignment measurements using the substrate marks PI etc. and image sensors (not shown) are used to measure and record alignment of the substrate relative to substrate table WTa/WTb. In addition, several alignment marks across the substrate W' will be measured using alignment sensor AS. These measurements are used in one embodiment to establish a "wafer grid", which maps very accurately the distribution of marks across the substrate, including any distortion relative to a nominal rectangular grid.

At step 204, a map of wafer height (Z) against X-Y position is measured also using the level sensor LS. Conventionally, the height map is used only to achieve accurate focusing of the exposed pattern. It may be used for other purposes in addition.

When substrate W' was loaded, recipe data 206 were received, defining the exposures to be performed, and also properties of the wafer and the patterns previously made and to be made upon it. To these recipe data are added the measurements of wafer position, wafer grid and height map that were made at 202, 204, so that a complete set of recipe and measurement data 208 can be passed to the exposure station EXP. The measurements of alignment data for example comprise X and Y positions of alignment targets formed in a fixed or nominally fixed relationship to the product patterns that are the product of the lithographic process. These alignment data, taken just before exposure, are used to generate an alignment model with parameters that fit the model to the data. These parameters and the alignment model will be used during the exposure operation to correct positions of patterns applied in the current lithographic step. The model in use interpolates positional deviations between the measured positions. A conventional alignment model might comprise four, five or six parameters, together defining translation, rotation and scaling of the 'ideal' grid, in different dimensions. Advanced models are known that use more parameters.

At 210, wafers W' and W are swapped, so that the measured substrate W' becomes the substrate W entering the exposure station EXP. In the example apparatus of Figure 1, this swapping is performed by exchanging the supports WTa and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly WTa) is all that is necessary to make use of the measurement information 202, 204 for the substrate W (formerly W') in control of the exposure steps. At step 212, reticle alignment is performed using the mask alignment marks M1, M2. In steps 214, 216, 218, scanning motions and radiation pulses are applied at successive target locations across the substrate W, in order to complete the exposure of a number of patterns.

By using the alignment data and height map obtained at the measuring station in the performance of the exposure steps, these patterns are accurately aligned with respect to the desired locations, and, in particular, with respect to features previously laid down on the same substrate. The exposed substrate, now labeled W" is unloaded from the apparatus at step 220, to undergo etching or other processes, in accordance with the exposed pattern.

The skilled person will know that the above description is a simplified overview of a number of very detailed steps involved in one example of a real manufacturing situation. For example rather than measuring alignment in a single pass, often there will be separate phases of coarse and fine measurement, using the same or different marks. The coarse and/or fine alignment measurement steps can be performed before or after the height measurement, or interleaved.

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down in previous layers (by the same apparatus or a different lithographic apparatus). For this purpose, the substrate is provided with one or more sets of marks. Each mark is a structure whose position can be measured at a later time using a position sensor, typically an optical position sensor. The position sensor may be referred to as "alignment sensor" and marks may be referred to as "alignment marks".

A lithographic apparatus may include one or more (e.g. a plurality of) alignment sensors by which positions of alignment marks provided on a substrate can be measured accurately. Alignment (or position) sensors may use optical phenomena such as diffraction and interference to obtain position information from alignment marks formed on the substrate. An example of an alignment sensor used in current lithographic apparatus is based on a self-referencing interferometer as described in US6961116. Various enhancements and modifications of the position sensor have been developed, for example as disclosed in US2015261097A1. The contents of all of these publications are incorporated herein by reference.

A mark, or alignment mark, may comprise a series of bars formed on or in a layer provided on the substrate or formed (directly) in the substrate. The bars may be regularly spaced and act as grating lines so that the mark can be regarded as a diffraction grating with a well-known spatial period (pitch). Depending on the orientation of these grating lines, a mark may be designed to allow measurement of a position along the X axis, or along the Y axis (which is oriented substantially perpendicular to the X axis). A mark comprising bars that are arranged at +45 degrees and/or -45 degrees with respect to both the X- and Y-axes allows for a combined X- and Y- measurement using techniques as described in US2009/195768A, which is incorporated by reference.

The alignment sensor scans each mark optically with a spot of radiation to obtain a periodically varying signal, such as a sine wave. The phase of this signal is analyzed, to determine the position of the mark and, hence, of the substrate relative to the alignment sensor, which, in turn, is fixated relative to a reference frame of a lithographic apparatus. So-called coarse and fine marks may be provided, related to different (coarse and fine) mark dimensions, so that the alignment sensor can distinguish between different cycles of the periodic signal, as well as the exact position (phase) within a cycle. Marks of different pitches may also be used for this purpose.

Measuring the position of the marks may also provide information on a deformation of the substrate on which the marks are provided, for example in the form of a wafer grid. Deformation of the substrate may occur by, for example, electrostatic clamping of the substrate to the substrate table and/or heating of the substrate when the substrate is exposed to radiation.

Figure 3 is a schematic block diagram of an embodiment of a known alignment sensor AS. Radiation source RSO provides a beam RB of radiation of one or more wavelengths, which is diverted by diverting optics onto a target, such as mark AM located on substrate W, as an illumination spot SP. In this example the diverting optics comprises a spot mirror SM and an objective lens OL. The illumination spot SP, by which the mark AM is illuminated, may be slightly smaller in diameter than the width of the mark itself.

Radiation diffracted by the mark AM is collimated (in this example via the objective lens OL) into an information-carrying beam IB. The term "diffracted" is intended to include zero-order diffraction from the mark (which may be referred to as reflection). A self-referencing interferometer SRI, e.g. of the type disclosed in US6961116 mentioned above, interferes the beam IB with itself after which the beam is received by a photodetector PD. Additional optics (not shown) may be included to provide separate beams in case more than one wavelength is created by the radiation source RSO. The photodetector may be a single element, or it may comprise a number of pixels, if desired. The photodetector may comprise a sensor array.

The diverting optics, which in this example comprises the spot mirror SM, may also serve to block zero order radiation reflected from the mark, so that the information-carrying beam IB comprises only higher order diffracted radiation from the mark AM (this is not essential to the measurement, but improves signal to noise ratios).

Intensity signals SI are supplied to a processing unit PU. By a combination of optical processing in the block SRI and computational processing in the unit PU, values for X- and Y-position on the substrate relative to a reference frame are output.

A single measurement of the type illustrated only fixes the position of the mark within a certain range corresponding to one pitch of the mark. Coarser measurement techniques are used in conjunction with this to identify which period of a sine wave is the one containing the marked position. The same process at coarser and/or finer levels are repeated at different wavelengths for increased accuracy and/or for robust detection of the mark irrespective of the materials from which the mark is made, and materials on and/or below which the mark is provided. Improvements in performing and processing such multiple wavelength measurements are disclosed below.

Throughout the description, as is conventional, the term mark or alignment mark may be used to describe a target used for alignment and the term target used to describe a metrology target used for process monitoring (e.g., an overlay or focus target). The term target can be used to generally describe either type of structure, and encompasses both targets specifically formed for metrology purposes and any other structure used for metrology, including actual product structure if said product structure is directly measured.

The concepts disclosed herein are equally applicable to alignment or other metrology techniques such as (e.g., scatterometry based) overlay and/or focus monitoring.

When radiation emitted by a metrology sensor interacts with a target and diffracts, such diffracted radiation comprises information regarding the target geometry. Therefore, for asymmetric (deformed) targets (e.g., asymmetric alignment marks or overlay/focus targets comprising unwanted asymmetry contributions attributable to effects other than overlay/focus), the metrology tool will detect a measurement value (e.g., position or overlay/focus value) which differs from the real measurement value on the wafer. This measurement error may be referred to, in the context of alignment, as alignment position error which is a measure of the difference of a measured aligned position of a target and a true aligned position of a target. This position difference causes overlay errors, which are strongly dependent on the type and magnitude of the asymmetry induced in the target, and depend also on the target depth.

Contributors to aligned position error comprise, for example:

- Grating asymmetry- unwanted grating asymmetry, for example in the form of floor tilt in the bottom grating or unequal side wall angles, cause a wavelength dependent aligned position error.
- Thickness variation and sensor aberrations- Layer thickness variation and interference within a stack can redistribute light within the pupil, which in combination with sensor aberrations causes aligned position error.

- Residual topography and surface roughness- When the signal strength is low, topography and surface roughness can cause aligned position error, which due to interference, is wavelength dependent.

To mitigate this, some scatterometers and/or alignment sensors measure using multiple different wavelengths and polarizations (e.g., in respective measurement channels or otherwise). In an ideal situation, all wavelengths/polarizations used in a multi-wavelength measurement would produce the same measurement result for a target on a geometrically perfect substrate. However, due to the asymmetries and unwanted target contributions, this is typically not the case and a wavelength dependent or color-to-color position variation is observed.

In the context of alignment, methods which enable correction for or mitigation for aligned position error are known, based on multiple wavelength measurements. Some solutions typically attempt to determine the most accurate wavelength for a particular target/stack and use this. An improved solution, described in more detail in US publication US2019/0094721 A1 (which is incorporated herein by reference), comprises a technique referred to as optimal color weighting (OCW). It should be appreciated that aligned position error scales differently for different colors (e.g. wavelengths or polarizations) as well as depending on layer thickness variations and the type of target being measured. OCW based methods aim to determine an optimal (e.g., weighted) combination (e.g., a measurement recipe) of all the colors used to minimize the impact of target deformations on a measurement value.

To be measurable using present alignment sensor technology, the measurable pitch or main pitch of an alignment mark may be orders of magnitude larger than the pitch and/or critical dimension (CD), or product features (the actual functional device features). It is often desirable to segment the alignment marks with product-like features to avoid damage to alignment marks and/or contamination of the device area as a consequence of wafer processing steps such as polishing, deposition or etch. Such product-like features may comprise features of a similar size and/or resolution than the product features (e.g., having a critical dimension (CD) of the same order of magnitude than the CD of the product features). Such alignment marks may be referred to as subsegmented alignment marks which comprise a subsegmentation of either the lines (first regions) and/or spaces (second regions) of the alignment mark. The periodic structure defined by these first regions and second regions may form a sensor-resolvable pitch, e.g., resolvable by an alignment sensor such as those described above. For example, either each line or each space may be segmented so as to comprise periodic sub-structures, e.g., a periodic (ID) array of multiple features having a product-magnitude CD and/or pitch. In another example, both of the lines and spaces may be segmented such that the "spaces" comprise periodic substructures comprising a periodic (ID) array of multiple features, each having a CD smaller than the multiple features comprised within the "lines" of the alignment mark (which also comprise periodic substructures) and therefore different optical characteristics. The latter type of mark is described in NL2002954A1, which is incorporated herein by reference. Note that subsegmentation is not necessarily ID periodic. Other examples of subsegmentation include contact array, staggered contact, tilted lines or any other subsegmented structure.

Such subsegmented alignment marks show a large sensitivity to focus errors and projection aberration during exposure, particularly when exposed on EUV lithographic systems. Such sensitivity may result in additional overlay penalty of up to 0.5 nm.

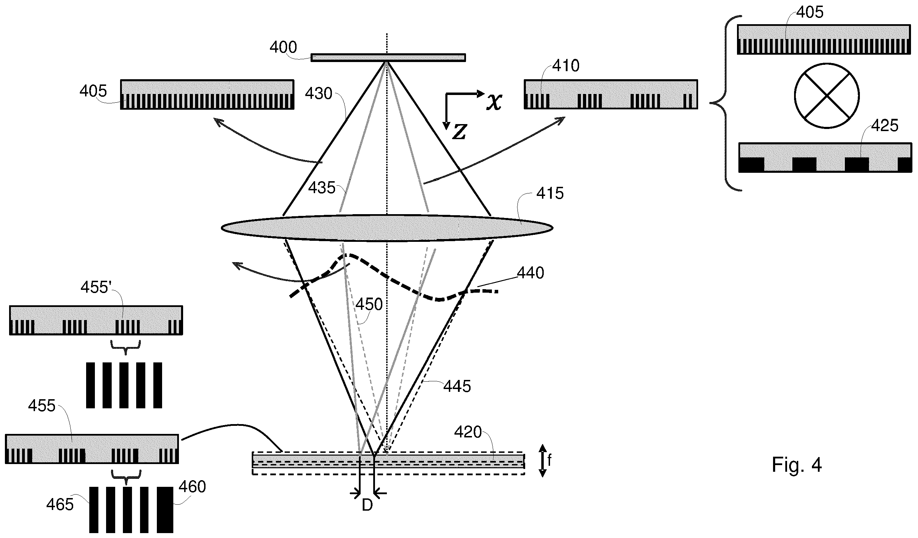

Figure 4 illustrates this issue. For the sake of simplicity, the arrangement of figure 4 shows a transmissive optical element i.e., imaging lens 415. However, this issue may be also extrapolated on reflective optical elements i.e., imaging mirrors. The drawing shows a reticle 400 comprising product structures 405 and one or more subsegmented alignment marks 410 being imaged via an imaging lens 415 onto a wafer 420. Subsegmented alignment mark 410 is shown as being comprised of a combination of a standard alignment mark 425 having an alignment sensor resolvable pitch and product structure 405. The black rays 430 represent the alignment mark rays (main pitch) through the system and the gray rays 435 represent the product feature rays (including that of the subsegmentation). Aberrations of the wavefront 440 (e.g., caused by lens imperfections, or mirror imperfections in other embodiments, and other factors) can result (particularly in the case of an EUV lithography tool or scanner) in a displacement difference D for the product features (e.g., having a product resolution) and the alignment mark (e.g., having a sensor readable resolution). The dotted rays for alignment mark 445 and product 450 show the ideal situation without wavefront aberration, such that there is no displacement difference (i.e., both of dotted rays 445 and 450 are focused on a common point). The magnitude of the displacement difference D is highly sensitive to focus differences/focus errors f, at least for EUV scanner systems and horizontal features.

As a result of this displacement difference, there will be a displacement difference between the main alignment mark features and its subsegmentation. This is illustrated by the printed alignment mark 455 on the wafer, which has an asymmetry for each feature (a detail of a single subsegmented feature is shown); in particular the segmentation of the rightmost (as shown) sub-feature 460 is larger than that of the leftmost sub-feature 465. For comparison, a perfectly exposed and therefore symmetrical subsegmented alignment mark 455' is also shown. Measurement of such mark will not be representative for the product, which will lead on product overlay error and hence also to an edge placement error.

Current solutions for this issue are typically based on optimizing the alignment mark and/or correction for the effects of this asymmetry by moving optical elements and illumination condition. However, this solution is not optimal because product features and the alignment/metrology mark can require different optimal illumination and aberration conditions. Also the most optimal mark design might not be possible due to limitation of mark detectability.

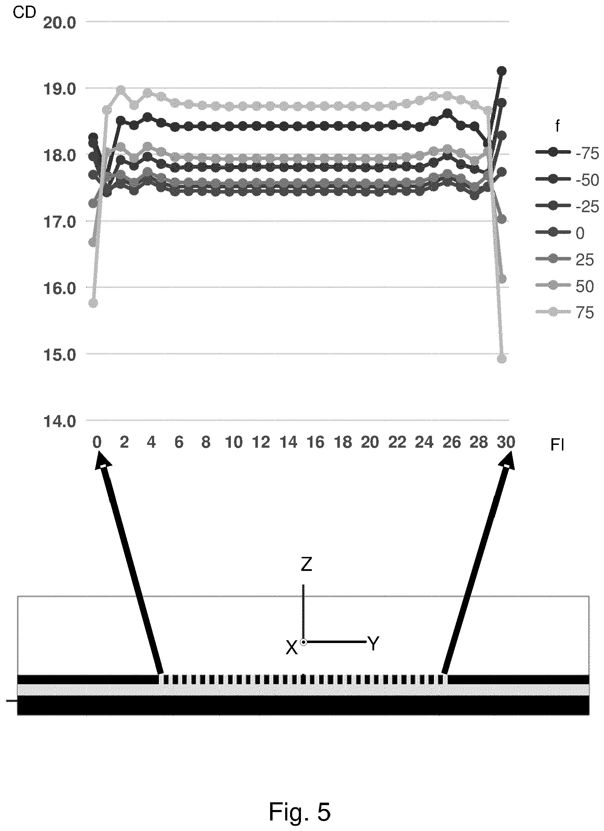

Figure 5 is a plot of CD for each sub-feature (i.e., against sub-feature index FI) of a single subsegmented alignment mark feature, for a number of different focus settings f. In this specific example, each alignment mark "line" feature (e.g., a first region) and/or space (e.g., a second region) is segmented into 30 sub-features as shown in the mark portion illustrated below the plot. The alignment mark is (optionally) exposed using optical proximity control (OPC) as is well known in the art. For best focus (f=0), CD varies little over the sub-features and therefore OPC works well. CD starts to vary when the mark is exposed out of focus. In particular, this variation is greatest at the edge of the mark (lowest and highest sub-feature indices), with this variation being noticeably asymmetrical; this effect increasing further with defocus. Measurement of such an alignment mark will be sensitive for the edge mark effect shown here. As such, while OPC is effective for best focus condition, it cannot compensate for variation in imaging focus.

There are known modelling techniques which can predict this asymmetrical segmented mark response to focus error. Such modelling techniques may be based on computational lithography techniques. In particular, such method may use "Design for Control" target modelling methods, abbreviated as D4C, and such as described in US20160140267A1, which is incorporated herein by reference. In a D4C method, individual steps of a lithography process are modeled into a single process sequence to simulate the physical substrate processing. That process sequence drives the creation of the device geometry as a whole, rather than "building" the device geometry element-by-element. Such a method may comprise providing design parameters for generating a metrology target; designing, by a computer apparatus, a three-dimensional geometrical structure of the metrology target based on a model of the lithography process and the design parameters for the metrology target, wherein the model of the lithography process represents a sequence of process steps; and visually rendering a gradual formation of the three-dimensional geometric structure of the metrology target at substrate level in the simulation domain.

As such, D4C or other suitable application may be used to build an alignment mark based on a patterning step. A lithography model (computational lithography) can be used to "print" (in a simulation) the alignment mark with different focus values and/or aberrations.

Such a simulation may use a (e.g., D4C) alignment sensor response simulation (and mark model), to determine an exposure parameter (e.g., focus and/or dose) sensitivity of a subsegmented alignment mark.

The inventors have appreciated that measurement radiation comprising different polarizations "see" or measure this asymmetrical mark with a respective polarization dependent offset (separate to any wavelength-to-wavelength variation per polarization state). The subsegmentation effectively acts as a polarizer for the measurement radiation.

Therefore a method of correcting metrology signal data relating to a structure (e.g., an alignment mark) on a substrate is proposed wherein a measured parameter value from metrology signal data is corrected to remove a polarization dependent offset resultant from an asymmetry in the structure (e.g., mark asymmetry), e.g., which may be caused by exposure parameter (e.g., focus) and aberration errors during layer exposure, using a simulated parameter value from simulated metrology signal data related to a simulated measurement of a model of said structure. The measured parameter value may comprise any suitable parameter, such as, for example, position. While this can be done measurement radiation comprising only a single polarization state, improved results will be obtained using measurement radiation comprising at least two polarization states (and the simulated measurement also comprising the same two polarization states).

Where the measurement radiation is broadband (comprising multiple wavelengths), the measured parameter value data and simulated parameter value data should show variation between different polarization states and variation between different wavelengths (assuming an imperfect mark). The difference between the two datasets is that the simulated data can be simulated to describe the wavelength-to-wavelength variation and the polarization dependent offset with respect to a zero aligned position (zero aligned position deviation APD). This relationship is not possible to establish on the measured data because, the measured data is used to correct for wafer load. Therefore the scanner does not control the wafer alignment to zero but uses measured signal to position the wafer, and measurement error will become error in overlay. It is therefore proposed to match the variation part of the simulated parameter value data (e.g., simulated swing curve) with the measured parameter value data (e.g., measured swing curve). Then, using the simulated swing curve, the 'true zero alignment position' can be estimated. A correction can then be made for the difference between the measurements at each wavelength and polarization and the estimated zero from simulated swing curve.

This enables a method of correcting metrology signal data relating to a structure on a substrate as disclosed herein, which enables removal of such a polarization dependent offset without the need for reference metrology, and which is different from a simple wavelength-to-wavelength averaging. As such, the method can be used to yield a corrected measurement signal, e.g., as described by a corrected swing curve. A corrected swing curve may describe a variation of measured parameter value or measured position against measurement condition (e.g., against a combination of wavelength and polarization) corrected for this polarization dependent offset. The corrected measurement signal can then be further corrected using other correction strategies such as selecting an optimal or preferred measurement recipe for a target and/or an OCW technique or similar, based on its corrected swing curve or otherwise.

As such, a method is proposed for correcting metrology signal data (e.g., alignment signal data) relating to a structure on a substrate, such as an alignment mark or target, and more specifically an asymmetrical alignment mark or target. The proposed method may use a predicted structure (e.g., alignment mark) shape from an imaging or exposure simulation and calculate expected alignment signal data for that structure. The simulated signal data can be compared to measurement data from the actual structure. This comparison may be used to remove this parasitic error or polarization dependent offset which results from the structure asymmetry and the combined effect of such asymmetry and any focus and aberration errors during exposure of the structure.

As such, a method of correcting metrology signal data is disclosed, the method comprising: obtaining measured metrology signal data (e.g., measured alignment signal data or measured position data) related to a measurement of a structure on a substrate with measurement radiation; obtaining simulated metrology signal data (e.g., simulated alignment signal data or simulated position metric signal data) related to a simulated measurement of a model of said structure using said measurement radiation; and using the simulated metrology signal data to correct the measured metrology signal data for at least a polarization dependent offset in the measured metrology signal data resultant from an asymmetry in said structure (and optionally to correct the shape of the swing curve) to obtain corrected measured metrology signal data.

In an embodiment, the measurement radiation may comprise at least two polarization states, such that the measured metrology signal data and simulated metrology signal data each relate to the at least two polarization states. In an embodiment, the measurement radiation may further comprise a plurality of wavelengths, or may comprise a plurality of wavelengths for each of said two polarization states. For example, the measurement radiation may comprise the same plurality of wavelengths for each of said two polarization states.

The corrected measured metrology signal data may comprise corrected measured signal values for each combination of wavelength and polarization state.

The correcting step may, in an embodiment, comprise obtaining simulated metrology signal data relating to an exposure parameter value corresponding to the actual exposure of the structure (i.e., of the actual exposed structure on the substrate), and determining the correction as a difference between the measured metrology signal data and the simulated metrology signal data. This may be possible if such an exposure parameter value is available. The exposure parameter may comprise focus, and a focus value may be obtained, for example, via focus metrology based on measurement of focus dependent targets on the substrate.

However, such an exposure parameter value is not always available (i.e., the actual focus setting for the exposure of the structure may be unknown). Where this is the case (or otherwise), the simulated metrology signal data may be used to determine at least a sensitivity metric describing the sensitivity (or variation) of an asymmetry metric with the exposure parameter (e.g., focus and/or dose) during exposure of the structure, and where the asymmetry metric may describe asymmetry in said structure. As such, the simulated metrology signal data may be simulated for different asymmetry metric values relating to different exposure parameter values, and the sensitivity metric then determined from this simulated metrology signal data.

The correction step may then comprise minimizing a difference between measured parameter values of said measured metrology signal data and fitted parameter values, the fitted parameter values comprising a combination (e.g., product) of the sensitivity metric and the asymmetry metric. Such a method may minimize the difference in terms of said asymmetry metric, such that the corrected measured parameter values comprise residual values of said minimization.

Therefore, such a method may comprise determining via simulation of the structure to be measured a sensitivity metric $\frac{\partial AP}{\partial Asy}$ where AP is the measured position or aligned position and *Asy* is the asymmetry metric for the structure. Note that it is possible to fit more than one asymmetry simultaneously. For example, imaging error can be due to focus and aberration (one or more aberration parameters). As such, measured position AP can be a vector and the sensitivity metric can be a matrix. The fitted position values $AP_{fit}$ may be defined as:

$$AP_{fit} = \frac{\partial AP}{\partial Asy} \times Asy$$

Therefore the optimization may be a minimization (e.g., a L2-norm minimization) of the difference of measured position values $AP_{mea}$ and fitted position values in terms of the asymmetry metric, using the sensitivity metric:

$$\arg\min_{Asy} \left\| AP_{mea} - \frac{\partial AP}{\partial Asy} \times Asy \right\|_2$$

A corrected swing curve may comprise the residuals of this minimization. The determined asymmetry metric may be used for other purposes, e.g., as a performance metric for monitoring purposes. As an additional step, it is possible to infer exposure focus from the determined asymmetry metric. The asymmetry metric is predictably dependent on focus using the simulation and therefore once the asymmetry metric is determined, exposure focus during exposure of the measured structure/alignment mark can be also determined. Measured focus can be used by the scanner for focus correction: e.g., a feedback correction (to determine a focus setting correction for the next exposure) or a feedforward correction (e.g., to determine a compensatory correction for any defocus/focus error).

The structure may comprise a periodic structure, the periodic structure comprising repetitions of a feature and a space, wherein one or both of said feature or said space is sub-segmented to comprise sub-features. The sub-features may have dimensions at the same order of magnitude as dimensions of functional product features on said substrate.

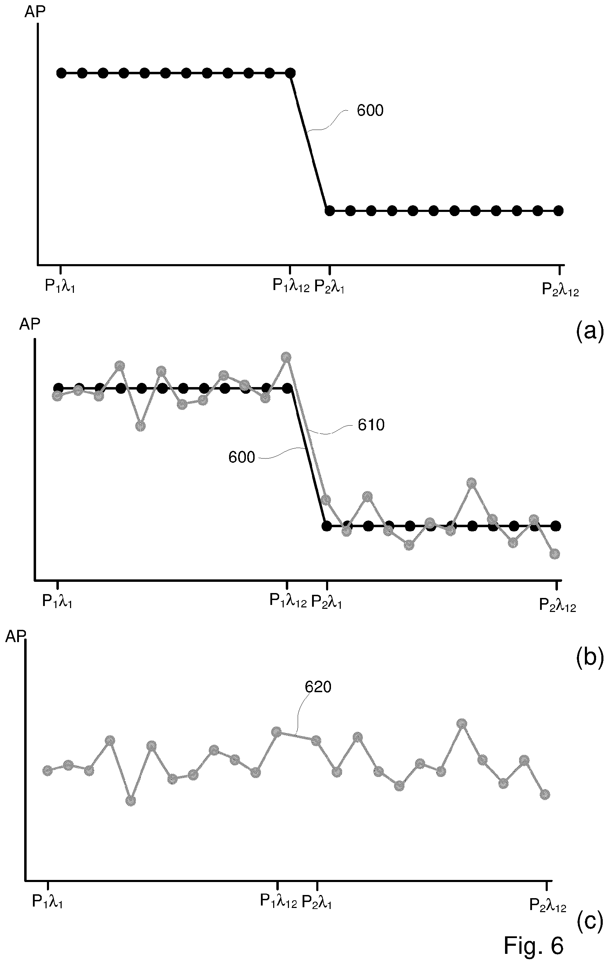

Figure 6 illustrates the principle behind the concepts disclosed herein. Figure 6(a) to (c) each show a plot of a position metric (e.g., aligned position) AP against wavelength/polarization combination $P_1\lambda_1$ to $P_2\lambda_{12}$ of the measurement radiation. In particular, the measurement radiation may comprise two (or more) polarization states, here $P_1$, $P_2$, and for each polarization state, a plurality of wavelengths (e.g., the same wavelengths). The different polarization states may comprise different linear polarization states, or any combination of different linear, circular or elliptical polarization states for example. In the specific example shown here, the number of wavelengths per polarization state may be 12, e.g., wavelengths $\lambda_1$ to $\lambda_{12}$. However, this is purely an exemplary number based on hardware characteristics of a particular tool, and the number of wavelengths may comprise any one or more wavelengths or any one or more wavelengths per two or more different polarization states.

Figure 6(a) shows a simulated swing curve 600 based on a simulated structure (simulated asymmetric alignment mark/target) and more specifically a simulation of the exposure of such a structure and a measurement thereof using measurement radiation having the abovementioned characteristics; i.e., in this specific embodiment, 12 different wavelengths for each of two different polarization states ($P_1$, $P_2$). It can be clearly seen that there is a very strong polarization dependence, but little or no wavelength dependence separate from the polarization dependence. The simulated swing curve 600 (or simulated swing curves for different values of the asymmetry metric) may be the simulated metrology signal data related to a simulated measurement of a model of said structure using the measurement radiation.

Figure 6(b) shows a measured swing curve 610 using the same measurement radiation characteristics and relating to the same structure; i.e., the simulated swing curve relates to a model equivalent of the structure measured to obtain the measured swing curve data. It can be seen that the measured swing curve shows substantially the same (e.g., predicted or simulated) strong polarization dependence. However, a further wavelength dependency is also apparent. The simulated swing curve 600 is shown again for comparison. The measured swing curve 610 may comprise the measured metrology signal data related to a measurement of the structure on a substrate with measurement radiation.

Figure 6(c) shows a difference between the measured and simulated swing curves, and represents a corrected swing curve 620, which has been corrected for the strong polarization dependence, leaving substantially only the wavelength dependence (possibly with a much smaller polarization dependence (polarization dependent offset) resulting from sources other than the asymmetry in the structure. As such that method may comprise determining a corrected swing curve (corrected metrology signal data, corrected alignment signal data or corrected position data) as a difference between the respective measured and simulated swing curves and/or as residuals of a minimization of measured and simulated position data in terms of mark asymmetry based on a simulated sensitivity metric.

Note that the swing curve shown are typical for marks measured in resist. For processed marks, the polarization difference is still quite pronounced but mark response within one polarization might be less flat. However, the principle is the same in either case.

In one embodiment, the 12 different wavelengths used in the polarization states may lay in the range between 400nm to 1000nm, preferable between 500nm and 900nm. In a further embodiment, all polarization states may comprise the same range of wavelengths.

The proposed methodology may be performed on production wafers prior to exposure of the next layer or a subsequent exposure on said substrate. As such, the method may comprise measuring an alignment mark on a substrate to obtain said measured metrology signal data or measured alignment signal data, performing the simulation to obtain said simulated metrology signal data or simulated alignment signal data and correcting the measured alignment signal data based on the simulated alignment signal data. The corrected alignment signal data can then be used for alignment during exposure of the next layer, e.g., to determine a positional correction for the exposure. This latter step may comprise performing a further processing of the alignment signal, e.g., determining alignment from only a subset of the measured wavelengths/polarization combinations or performing an optical color weighting. Such a method may be performed for every alignment mark on every production wafer, or for a subset of marks per wafer.

The proposed method may further comprise performing an exposure on said substrate in accordance with the positional correction.

In addition, in order to determine and monitor a degree of exposure error which has occurred, a fitted alignment signal may be fitted to the measured alignment signal data for each mark. Such a fit will yield an indication of the magnitude of any exposure error. In this way, it is possible to calculate statistics per mark relating to the exposure error for every mark.

In addition to performing the method on production wafers, the method may be employed on one or more calibration wafers, e.g., to tune the model with respect to the actual structure and stack and/or to calibrate or qualify scanner.

Any mention of a swing curve described herein may comprise, for example, variation of a performance parameter or measurement parameter as function of wavelength and/or polarization. More specifically the measured parameter data may comprise one or more of (in any combination):

- an aligned position swing curve;
- a signal strength swing curve;
- an intensity imbalance swing curve;
- an intensity asymmetry metric swing curve such as an A+/A- curve (e.g., for intensity asymmetry based overlay techniques where A+ is the intensity asymmetry or intensity difference of complementary diffraction orders from a first biased or positively biased target and A- is the intensity asymmetry or intensity difference of complementary diffraction orders from a second biased or negatively biased target).

It should be appreciated that, while the concepts disclosed herein have been described in terms of correcting measurements of alignment marks in the context of alignment metrology, it is not limited to this. The concepts disclosed herein are equally applicable to other metrology applications such as post-exposure metrology (e.g., overlay metrology or focus metrology); e.g., using a scatterometer.

Further embodiments are disclosed in the subsequent list of numbered clauses:

1. A method of correcting metrology signal data relating to a structure on a substrate, the method comprising:

obtaining measured metrology signal data related to a measurement of the structure on a substrate with measurement radiation;
obtaining simulated metrology signal data related to a simulated measurement of a model of said structure using said measurement radiation; and
using the simulated metrology signal data to correct the measured metrology signal data for at least a polarization dependent offset in the measured metrology signal data resultant from an asymmetry in said structure, to obtain corrected measured metrology signal data.

2. A method as defined in clause 1, wherein the measurement radiation comprises at least two polarization states, such that the measured metrology signal data and simulated metrology signal data each relate to the at least two polarization states.

3. A method as defined in clause 2, wherein said measurement radiation comprises a plurality of wavelengths for each of said at least two polarization states.

4. A method as defined in clause 3, wherein said measurement radiation comprises the same plurality of wavelengths for each of said two polarization states.

5. A method as defined in clause 3 or 4, wherein said corrected measured metrology signal data comprises corrected measured parameter values for each combination of wavelength and polarization state.

6. A method as defined in any preceding clause, wherein said correcting step comprises determining a difference between measured parameter values of said measured metrology signal data and simulated parameter values of said simulated metrology signal data.

7. A method as defined in any of clauses 1 to 5, wherein said simulated metrology signal data is used to determine at least a sensitivity metric describing the sensitivity of an asymmetry metric of the structure with an exposure parameter during exposure of the structure, the asymmetry metric describing asymmetry in said structure; and said correcting step comprises:

minimizing a difference between measured parameter values of said measured metrology signal data and fitted parameter values, the fitted parameter values comprising a combination of the sensitivity metric and the asymmetry metric.

8. A method as defined in clause 7, wherein said corrected measured parameter values comprise or are determined from residual values of said minimization.

9. A method as defined in clause 7 or 8, wherein the exposure parameter is focus and/or one or more projection optics aberration parameters.

10. A method as defined in clause 7, 8 or 9, wherein said minimizing step comprises minimizing said difference in terms of the asymmetry metric.

11. A method as defined in clause 10, comprising determining an exposure parameter value describing the exposure parameter during exposure of said structure from said asymmetric metric.

12. A method as defined in clause 11, comprising using said exposure parameter value to determine a exposure parameter correction for exposure on a subsequent layer and/or a compensatory correction for an exposure parameter error described by said exposure parameter value.

13. A method as defined in any preceding clause, wherein said structure comprises a periodic structure, the periodic structure comprising repetitions of a first region and a second region, said first region and second region having different optical characteristics so as to form said periodic structure, wherein one or both of said feature or said space is sub-segmented to comprise sub-features.

14. A method as defined in clause 13, wherein the sub-features have dimensions at the same order of magnitude as dimensions of functional product features on said substrate.

15. A method as defined in any preceding clause, wherein said simulated metrology signal data is obtained from a modelling simulation for modelling the structure and a metrology device response simulation for simulating a metrology signal response when measuring the modelled structure.

16. A method as defined in clause 15, wherein the modelling simulation is used to model the structure for different exposure parameter settings.

17. A method as defined in any preceding clause, wherein said measured metrology signal data comprises measured alignment signal data, and said structure comprises an alignment mark.

18. A method as defined in clause 17, wherein said alignment mark is comprised on a product substrate, and said corrected measured metrology signal data comprises corrected alignment signal data for alignment of a subsequent exposure on said substrate.

19. A method as defined in clause 18, comprising performing said method for each alignment mark on said product substrate.

20. A method as defined in clause 17, 18 or 19, comprising determining a positional correction based on said corrected alignment signal data.

21. A method as defined in clause 20 comprising performing an exposure on said substrate in accordance with said positional correction.

22. A method as defined in any of clauses 1 to 16, wherein said measured metrology signal data comprises measured overlay signal data or focus signal data, and said structure comprises an overlay target or focus target.

23. A computer program comprising program instructions operable to perform the method of any of any preceding clause, when run on a suitable apparatus.

24. A non-transient computer program carrier comprising the computer program of clause 23.

25. A processing arrangement comprising:

the non-transient computer program carrier of clause 24; and
a processor operable to run the computer program comprised on said non-transient computer program carrier.

26. A metrology apparatus comprising the processing arrangement of clause 25.

27. An alignment sensor comprising the processing arrangement of clause 25.

28. A lithographic apparatus comprising:

the alignment sensor of clause 27;
a patterning device support for supporting a patterning device; and
a substrate support for supporting a substrate.

It should be appreciated that the term color is used throughout this text synonymously with wavelength and the colors may include those outside the visible band (e.g., infrared or ultraviolet wavelengths).

While specific embodiments of the invention have been described above, it will be appreciated that the invention may be practiced otherwise than as described.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 1-100 nm), as well as particle beams, such as ion beams or electron beams.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

The breadth and scope of the present invention should not be limited by any of the above-described exemplary embodiments, but should be defined only in accordance with the following claims and their equivalents.

**Claims**

1. A method of correcting metrology signal data relating to a structure on a substrate, the method comprising:

obtaining measured metrology signal data related to a measurement of the structure on a substrate with measurement radiation;
obtaining simulated metrology signal data related to a simulated measurement of a model of said structure using said measurement radiation; and
using the simulated metrology signal data to correct the measured metrology signal data for at least a polarization dependent offset in the measured metrology signal data resultant from an asymmetry in said structure, to obtain corrected measured metrology signal data.

2. A method as claimed in claim 1, wherein the measurement radiation comprises at least two polarization states, such that the measured metrology signal data and simulated metrology signal data each relate to the at least two polarization states.

3. A method as claimed in claim 2, wherein said measurement radiation comprises a plurality of wavelengths for each of said at least two polarization states; and optionally the same plurality of wavelengths for each of said two polarization states.

4. A method as claimed in claim 3, wherein said corrected measured metrology signal data comprises corrected measured parameter values for each combination of wavelength and polarization state.

5. A method as claimed in any preceding claim, wherein said correcting step comprises determining a difference between measured parameter values of said measured metrology signal data and simulated parameter values of said simulated metrology signal data.

6. A method as claimed in any of claims 1 to 4, wherein said simulated metrology signal data is used to determine at least a sensitivity metric describing the sensitivity of an asymmetry metric of the structure with an exposure parameter during exposure of the structure, the asymmetry metric describing asymmetry in said structure; and said correcting step comprises:

minimizing a difference between measured parameter values of said measured metrology signal data and fitted parameter values, the fitted parameter values comprising a combination of the sensitivity metric and the asymmetry metric.

7. A method as claimed in claim 6, wherein said corrected measured parameter values comprise or are determined from residual values of said minimization.

8. A method as claimed in claim 6 or 7, wherein the exposure parameter is focus and/or one or more projection optics aberration parameters.

9. A method as claimed in claim any of claims 6 to 8, wherein said minimizing step comprises minimizing said difference in terms of the asymmetry metric.

10. A method as claimed in any preceding claim, wherein said simulated metrology signal data is obtained from a modelling simulation for modelling the structure and a metrology device response simulation for simulating a metrology signal response when measuring the modelled structure.

11. A method as claimed in any preceding claim, wherein said measured metrology signal data comprises measured alignment signal data, and said structure comprises an alignment mark.

12. A method as claimed in claim 11, wherein said alignment mark is comprised on a product substrate, and said corrected measured metrology signal data comprises corrected alignment signal data for alignment of a subsequent exposure on said substrate.

13. A method as claimed in claim 11 or 12, comprising:

   determining a positional correction based on said corrected alignment signal data; and
   performing an exposure on said substrate in accordance with said positional correction.

14. A computer program comprising program instructions operable to perform the method of any of any preceding claim, when run on a suitable apparatus.

15. An alignment sensor comprising:

   a non-transient computer program carrier the computer program of claim 14; and
   a processor operable to run the computer program comprised on said non-transient computer program carrier.

Fig. 1

Fig. 2

Fig. 3

Fig. 4

EP 4 303 658 A1

Fig. 5

AP

P₁λ₁    P₁λ₁₂ P₂λ₁    P₂λ₁₂

(a)

AP

P₁λ₁    P₁λ₁₂ P₂λ₁    P₂λ₁₂

(b)

AP

P₁λ₁    P₁λ₁₂ P₂λ₁    P₂λ₁₂

(c)

Fig. 6

Europäisches
Patentamt

European
Patent Office

Office européen
des brevets

# EUROPEAN SEARCH REPORT

Application Number

EP 22 18 3121

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2021/013726 A1 (ASML NETHERLANDS BV [NL]) 28 January 2021 (2021-01-28) * abstract * * figures 4-6,9-14 * * paragraphs [0002], [0008], [0054] – [0066], [0082] – [0108] * | 1-15 | INV. G03F7/20 G03F9/00 |
| A | US 2019/033726 A1 (ADAM IDO [IL] ET AL) 31 January 2019 (2019-01-31) * abstract * * figures 1-3 * * paragraphs [0002], [0019], [0033] – [0035] * | 1-15 | |
| A | "ASYMMETRY EXTENDED GRID MODEL FOR WAFER ALIGNMENT", RESEARCH DISCLOSURE, KENNETH MASON PUBLICATIONS, HAMPSHIRE, UK, GB , vol. 685, no. 62 1 May 2021 (2021-05-01), XP007149393, ISSN: 0374-4353 Retrieved from the Internet: URL:ftp://ftppddoc/RDData685_EPO.zip Pdf/685062.pdf * the whole document * | 1-15 | TECHNICAL FIELDS SEARCHED (IPC) G03F |

The present search report has been drawn up for all claims

| Place of search | Date of completion of the search | Examiner |
|---|---|---|
| Munich | 19 December 2022 | Andersen, Ole |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
...........................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 22 18 3121

This annex lists the patent family members relating to the patent documents cited in the above-mentioned European search report.
The members are as contained in the European Patent Office EDP file on
The European Patent Office is in no way liable for these particulars which are merely given for the purpose of information.

19-12-2022

| Patent document cited in search report | | Publication date | Patent family member(s) | | Publication date |
|---|---|---|---|---|---|
| WO 2021013726 | A1 | 28-01-2021 | CN | 114144732 A | 04-03-2022 |
| | | | EP | 3770682 A1 | 27-01-2021 |
| | | | IL | 289742 A | 01-03-2022 |
| | | | KR | 20220025851 A | 03-03-2022 |
| | | | TW | 202119134 A | 16-05-2021 |
| | | | US | 2022276569 A1 | 01-09-2022 |
| | | | WO | 2021013726 A1 | 28-01-2021 |
| US 2019033726 | A1 | 31-01-2019 | CN | 110312966 A | 08-10-2019 |
| | | | DE | 112017007043 T5 | 16-01-2020 |
| | | | JP | 7179742 B2 | 29-11-2022 |
| | | | JP | 2020510857 A | 09-04-2020 |
| | | | KR | 20190107298 A | 19-09-2019 |
| | | | SG | 11201906424W A | 27-08-2019 |
| | | | TW | 201835679 A | 01-10-2018 |
| | | | US | 2019033726 A1 | 31-01-2019 |
| | | | WO | 2018147938 A1 | 16-08-2018 |

EPO FORM P0459

For more details about this annex : see Official Journal of the European Patent Office, No. 12/82

## REFERENCES CITED IN THE DESCRIPTION

**Patent documents cited in the description**

- US 2006033921 A1
- US 2010201963 A1
- US 2006066855 A1
- WO 2009078708 A
- WO 2009106279 A
- US 20110027704 A
- US 20110043791 A
- US 2011102753 A1
- US 20120044470 A
- US 20120123581 A

- US 20130258310 A
- US 20130271740 A
- WO 2013178422 A1
- US 6961116 B
- US 2015261097 A1
- US 2009195768 A
- US 20190094721 A1
- NL 2002954 A1
- US 20160140267 A1